# EUROPEAN PATENT SPECIFICATION

(11) **EP 1 735 854 B1**
(45) Date of publication and mention of the grant of the patent: **26.03.2008**
(21) Application number: 05734213.1
(22) Date of filing: 14.04.2005
(51) Int. Cl.: H01L 51/40

(54) **METHOD OF PATTERNING A FUNCTIONAL MATERIAL ON TO A SUBSTRATE**
VERFAHREN ZUR STRUKTURIERUNG EINES FUNKTIONALEN MATERIALS AUF EIN SUBSTRAT
PROCEDE DE FORMATION DE MOTIFS D'UN MATERIAU FONCTIONNEL SUR UN SUBSTRAT

(30) Priority: 16.04.2004 GB 0408569
(43) Date of publication of application: 27.12.2006
(73) Proprietor: Exitech Limited, Yarnton, Oxford OX5 1QU (GB)
(72) Inventor: BUCKLEY, Alastair Robert, Sheffield, S117AG (GB); GIEBELER, Carsten, Edinburgh EH12 8PZ (GB); VOIGT, Monika, Sheffield S10 1NP (GB); LIDZEY, David George, Sheffield S7 1HE (GB); BOEHLEN, Karl Lukas, Oxford OX2 0AH (GB); FIERET, Jacob, Shenington,Oxford OX15 6NE (GB)
(74) Representative: Hanson, William Bennett
(86) International application number: PCT/GB2005/001416
(87) International publication number: WO 2005/101505

(56) References cited:
- WO-A-98/53510
- WO-A-03/086024
- US-A1- 2002 145 381
- US-A1- 2003 194 882
- US-A1- 2003 214 232

## Description

### BACKGROUND OF THE INVENTION

This invention relates to a method of patterning a functional material on to a substrate. The invention has particular application to electronic devices such as polymer light emitting diode (PLED) devices. However, the invention is also applicable to other electronic devices and to biochemical sensors.

PLED devices have been known for approximately 15 years. In such devices, one or more layers of organic material are sandwiched between two electrodes, an anode and a cathode. An electric field is applied to the device, causing electrons to be injected from the cathode into the device and positive charges, typically referred to as holes, to be injected from the anode contact into the device. The positive and negative charges recombine in the electroluminescent organic layer and produce photons of visible or near infrared light. The energy of the photons generated depends on the chemical structure and the electronic properties of the electroluminescent organic layer in which the photons are generated.

Consequently, the color of the light emitted from a PLED can be controlled by careful selection of the organic electroluminescent material. In addition, color changing materials may be used to alter the color of the light emitted from the electroluminescent layer of the PLED, or color filters added onto the device to restrict the colour of light emitted from the device.

PLED displays are predicted to play an important role in small, portable electronic devices such as pagers, mobile phones or head mounted displays but they are also seen as a feasible alternative for larger displays, for example for laptop computer or television screens. PLEDs are able to generate sufficient light to be used in displays under a variety of ambient light conditions (from little or no ambient light to bright ambient light). PLED devices can be fabricated relatively cheaply. PLEDs have a very low activation voltage that is compatible with standard CMOS (complementary metal-oxide-semiconductor) (3.5 V), a fast response time if the emissive layers are very thin (around 100 nm) and a very high brightness. The brightness of a PLED is in the first instant proportional to the electrical current passing through the device. Furthermore, PLED have the added advantage that their emission is approximately Lambertian, which results in a very wide viewing angle.

A PLED may be designed to be viewed either from the "top" (i.e. light is emitted through the contact that is furthest away from the substrate), which is referred to as "top emitting", or from the "bottom" (i.e. through the transparent substrate), which is referred to herein as "bottom emitting". The structure between the viewer and the organic light emitting material should be sufficiently transparent to allow the emitted light to be passed through. In many applications it is advantageous to build "top emitting" PLEDs, for example when the substrate material is non-transparent, and/or when the display is built directly onto opaque silicon driver chips for active matrix addressing.

Displays based on organic electroluminescent materials are usually composed of a two dimensional matrix of pixels, each of which comprises a PLED. Such displays generally include an addressing circuit to control the matrix of pixels. In an active matrix PLED, the row and column structure is built into the substrate using standard semiconductor fabrication techniques. In this case, the substrate has an array of discrete electrodes, each one corresponding to a point in the matrix.

In contrast, in a passive matrix addressed PLED display, numerous PLEDs are formed on a single substrate and arranged in groups forming a regular grid pattern. Several PLED groups forming a column of the grid may share a common anode or cathode line. The individual PLEDs in a given group emit light if their anode line and cathode line are activated at the same time.

A display based on organic electroluminescent materials can be monochromatic, that is, each pixel emits light of the same color. The thin organic electroluminescent film in such monochrome displays is usually formed via a spin-coating process to obtain a uniform polymer film of controlled thickness.

Alternatively, various pixels of a display based on organic electroluminescent materials may emit light in various different colors. A full-color display is formed from an array of pixels comprising at least one red, one green and one blue sub-pixel. The sub-pixels in any particular pixel can be activated in various combinations to generate an entire spectrum of colors.

Although substantial progress has been made in the development of full-color PLED displays, additional challenges remain. One approach to generate full-color PLED displays is to provide a self-emissive pixelated display with adjacent PLED sub-pixels emitting red, green and blue light. This approach would give, in principle, the most efficient display structure, as no light would be lost through absorption by a color filter or a color changing material. However, one of the main obstacles to overcome here is the compatibility of the solvents for the red, green and blue polymers. Currently used light emitting polymers for display applications are in general soluble in the same limited range of aromatic non-polar solvents which include, but are not limited to, toluene, xylene, chloroform and tetrahydrofuran. As a consequence, after having deposited a first layer of said polymer material from a solution and patterned it using various processes described below, any subsequent deposition of a second polymer layer from a common solvent will result in either a complete removal of the previously deposited polymer film or a mixing of the two polymers. Both scenarios are not desirable as they lead either to a complete device failure or to color contamination and bad control over color coordinates. Mixing of the polymers can even happen without using a common solvent for the two polymers. Consequently direct contact between light emitting polymers during a deposition process and/or a patterning process should be avoided.

An additional problem related to organic light emitting materials is that they are very delicate and cannot be directly exposed to any processing steps such as plasma etching or UV radiation without typically suffering severe damage. Process induced damages reduce the device lifetime, decrease the photoluminescence efficiency and quantum efficiency of the device and lead to generally not acceptable device performance.

To overcome the problems described above a variety of technologies and processes have been developed. In the following section, various technologies and processes are discussed in more detail and their limitations for achieving high resolution, efficient and reliable polymer light emitting displays with small feature size are highlighted.

Inkjet-printing is one technology that has emerged, which overcomes solvent compatibility problem and prevents the red, green and blue polymers from mixing during the deposition process. In Inkjet-printing tiny drops of a given polymer solution are dispensed onto a substrate on which already exists a structure of pre-patterned pixels. The volume of the respective polymer solution is controlled very accurately so that each pixel is filled precisely and no spillage or mixing of polymers occurs during this process. Inkjet-technology has found widespread applications in the production of PLED displays and is now considered an efficient manufacturing route for full color PLED displays. However, inkjet technology is currently only applicable to displays with pixel sizes of greater than 30 micrometers. The minimum pixel size that can be achieved with inkjet printing technology is very much proportional to the smallest droplet size that can be dispensed reproducibly. The smallest droplet size that can be dispensed at the time of writing is around 25-30 micrometers. Therefore producing displays with a pitch of 10 micrometers is not possible, as one droplet would automatically cover three pixels. Other problems related to ink-jet printing in such small dimensions are volume control of the droplets, placement accuracy of the polymer droplet and the positioning accuracy of the ink-jet print nozzle.

An alternative approach for making full color PLED displays is to use a white emitting polymer in combination with a color filter that is precisely aligned over each PLED sub pixel. The color filters transmit certain discrete wavelengths generating red, green or blue light for specific sub-pixels. The disadvantage of this approach is that color filters absorb a significant proportion of the initially emitted light and are therefore very inefficient.

A more efficient technique is to use a monochrome PLED array in combination with color conversion materials which are aligned accurately to the individual sub pixels. The working principal of color conversion materials is that they absorb higher energy photons (low wavelength light) and emit photons at a lower energy (higher wavelength) by fluorescence or phosphorescence (see US-A-5,294,870). This approach has the potential disadvantage of color bleeding of blue light into red pixels since the red dyes might not efficiently absorb the blue light. Another problem with this approach is that efficient color conversion materials that can be patterned to 4-5 micrometer size are, to our knowledge, not readily available.

A patterning process for polymer light emitting materials based on a lithography process would certainly be one route to achieve full color polymer displays. In the literature a publication by D.G.Lidzey *et al.* Synthetic Metals 82 (1996) describes a patterning process for polymer light emitting diodes using a standard photolithography process consisting of the following steps: A thin polymer film is spin-coated onto a substrate, then a layer of photoresist is spin-coated onto the polymer layer. The photoresist is then exposed through a shadow masked, developed and the exposed photoresist is then washed off. The cathode metal is then evaporated making contact to the light-emitting polymer where the exposed photoresist has been washed off. The remaining photoresist is then dissolved in acetone.

The process described by Lidzey *et al.* describes the patterning of the cathode metal using a photolithography process. This process could be used to define pixels for a monochrome display but it is not suitable for full color display application, as it does not describe a method for avoiding contamination of the light emitting polymers during processing and it does not avoid polymer mixing.

A different approach to pattern the metal cathode was proposed by Kim et al. (Science, Vol. 288, 5 May 2000). This process describes the patterning of the cathode of organic light emitting diodes using a cold welding process. In this process, a metal-coated stamp composed of a rigid material such as Si is pressed onto an unpatterned film consisting of the organic device layers coated with the same contact layer as that used to coat the stamp. When a sufficiently high pressure is applied, an intimate metallic junction is formed between the metal layers on the stamp and the film, leading to a cold-welded bond. When the stamp and the film are separated, the metal cathode breaks sharply, forming a well-defined patterned electrode.

This process is applicable to produce monochrome displays but does not lend itself to the production of full color RGB displays as it is only able to pattern the cathode and not the light emitting material. Another drawback of this process is that it does not work very well with top emitting active matrix displays that require transparent, highly reactive, low work function thin film cathodes from materials like calcium, magnesium etc. These materials do not lend themselves to the cold welding process because they react very aggressively and form oxides or nitrides at the interfaces that prevent an effective cold welding process.

A different way of patterning materials has been developed in recent years using laser ablation. This technique uses excimer laser radiation in the wavelength range from 192 nm to 332 nm to selectively ablate material of a substrate. There have been various publications about possible applications of this technique and the most relevant to our invention will be discussed here in more detail.

Noach et al. (Appl. Phys. Lett. 69 (24), 1996) reported on the microfabrication of light emitting diode arrays made from light emitting conjugated polymers. The process is based on the direct photoablation with the 193 nm emission of an excimer laser. The process described in this paper comprises of the following steps: 1) patterning of the indium tin oxide (ITO) covered glass substrate using the excimer laser, 2) spin-coating the light emitting polymer onto the patterned substrate, 3) evaporation of the cathode contact (aluminum), 4) ablation of both aluminum and partially the polymer layer via excimer laser radiation through a bar grid that was placed orthogonally relative to the direction of the original ITO lines. This process again allows the fabrication of monochrome displays but it does not allow the production of full color displays as the deposition of a second polymer via spin coating would dissolve or damage the already patterned pixels.

Another process to obtain full color displays via excimer laser patterning has been described in WO 99/03157. This process basically comprises the following steps:
I. Deposition of first organic light emitting material(s) onto a substrate that is overlaid with a preferably transparent hole-transporting layer.
II. Deposition of an electron injection material (MgAg) on to said first organic layer:
III. Selective laser ablation of both the electron injection material and the first organic light emitting material from undesired areas of the substrate to obtain pixels that emit a first color of light.
IV. Deposition of second light emitting material(s) on to said substrate.
V. Deposition of an electron injection material (MgAg) on to said second organic layer.
VI. Selective laser ablation of both the electron injection material and the first organic light emitting material from undesired areas of the substrate to retain the pixels that emit a first color of light and to create pixels that emit a second color of light.
VII. The same process steps as described above are repeated to obtain pixels that emit a third color of light.

The above process is certainly feasible if the organic materials are evaporated or deposited from solid state. However, for solution processed organic light emitting materials such as most conjugated polymers e.g. poly(phenylene vinylene) (PPV), polyfluorenes, etc this process will not work. Most conjugated polymers that are currently used in the field of organic light-emitting displays are soluble in non-polar aromatic solvents. This means that process step IV in the above process would wash off or contaminate the first organic layer that has been deposited. This would lead to ill-defined device characteristics and very likely to a complete device failure.

Another application of patterning materials using excimer radiation is described in EP-A2-0480703. In this document, a process is described to pattern metal onto a substrate. For this purpose, one or more metal films are deposited onto the same substrate, at least one of them being highly UV-absorbing. The resulting structure is scanned with a UV laser having sufficient power to ablate the first and, if applicable, second layer from the substrate in a pattern that is determined by the scanning pattern of the laser beam. It is reported that if the substrate is a polymer the portion of the substrate from which the metal was ablated is greatly roughened.

Such damage is not acceptable to any electro-optically active material as employed in the field of organic light emitting diodes and polymer electronics. Any damage will alter the properties of the organic materials in an ill-defined manner and will have undesired consequences on both lifetime and performance. Similar problems were also reported in WO 98/53510. In this document, the cathode was pre-patterned using laser ablation but then a second method that was less destructive than laser ablation to the underlying organic layers was necessary to complete the patterning.

A very general approach to transferring a pattern onto a substrate is described in US-A-5505320. A first layer of a first material is deposited onto a substrate followed by a second layer of material where the second layer is of different material from the first layer. A layer of a dry imaging polymeric composition is then deposited on top of the second layer and an excimer laser is used to define a pattern in the dry imaging polymeric composition. The exposed portions of the second layer are then etched with the first layer acting as an etch stop. The remaining dry imaging polymeric material is ablated from the defined area to expose the second layer of material. After this, the remaining exposed areas of the first layer are etched to expose the substrate.

The above-mentioned document describes how a certain pattern can be transferred into metal layers that have been deposited onto a substrate to obtain interconnection between electronic circuits. However, this process cannot be used for a pattering process of organic electro-optically active material like light emitting diodes. There is no mention in the document of how to overcome the compatibility problem of the solvents for the red, green and blue emitting material, or in other words how can it be assured that the previously deposited light emitting polymer is not washed off if the second polymer is deposited from solution? It is also not clear from this document how to remove material one and material two after the organic light-emitting polymer has been deposited.

A very similar process to that outlined above is described in US-A-5196376. In this patent, a thin layer of polymer is deposited onto a metal layer by vaporizing a corresponding monomer in a vacuum and allowing the same to deposit onto the layer of metal substantially as a polymer. The said polymer layer is then patterned with a laser by removing said polymer to expose selected areas of the metal layer therebeneath, selectively etching the exposed areas of the metal to pattern a metal layer in accordance with a pattern defined by the thin layer of polymer. This process is also not applicable to patterning organic light emitting polymers, as it gives no clue as to how to overcome the compatibility problems of the solvent in which the light emitting polymers are dissolved. It is also not apparent from this patent how the polymer layer that has been used to define the pattern and the metal layer can be removed without damaging the light emitting polymers. The suggested process of plasma etching will lead to unrecoverable damage of the light-emitting polymer.

The discussion above emphasizes an existing problem in the production of full color display. One can either apply a uniform single coating of a light emitting polymer from a solution via spin coating and pattern it using various techniques to achieve high resolution monochrome devices and then convert the light via color filters or color changing materials but with the consequent light loss; or selectively deposit individual polymer color elements via e.g. inkjet printing but then have a more expensive and less scalable process for volume production that does not lend itself to pixel sizes below 30 µm.

WO 03/086024 describes a method of patterning a functional material according to the preamble of claim 1.

US 2003/0194882 describes laser patterning of a metal electrode without significant ablation of an organic material below the electrode.

### SUMMARY OF THE INVENTION

According to the invention there is provided a method of patterning a functional material on to a substrate according to claim 1. The preferred or optional features of the invention are defined in the dependent claims.

The present invention provides a universal patterning process for organic light emitting polymers. The invention makes use of at least one sacrificial, preferably organic, layer that is able to protect layers of functional material. The material that forms said sacrificial and protective layer must firstly, be soluble in a solvent system that does not cause any non-recoverable damage to the functional, e.g. organic electroluminescent material. It must also protect the underlying functional material from any potentially damaging solvents or process steps.

A particular species of the present invention provides a method of patterning and fabricating color PLED displays. Preferably, the present invention relates to methods for fabricating full-color PLED displays that have red, green and blue sub-pixels that can be activated in any combination to produce any color in the visible or near infra red light spectrum. This process can be used to produce self-emissive, pixelated displays with adjacent sub-pixels emitting red, green and blue light. The patterning of each different light emitting material occurs in a process that is detailed herein. A first layer of organic electroluminescent material is deposited on to a substrate. Then a second layer of material, preferably a water soluble organic material such as poly(vinyl alcohol) (PVA) is deposited onto the first layer of organic electroluminescent material. The second layer of material should be soluble in a solvent system that is incompatible with the solvent system of the organic electroluminescent material and it should not cause any significant damage to the functionality of the electroluminescent material. The thickness of the said second organic layer should be less than 1 µm.

We have successfully shown that for example water based polymers such as PVA can be deposited onto and later removed from the organic electroluminescent material without causing any significant change in the photoluminescent spectra of the organic electroluminescent materials. The performance of electroluminescent devices that were fabricated from polymer films that were exposed to water prior to the cathode deposition was also comparable to that of standard devices, when care is taken to remove any adsorbed water from the functional polymer film using for example a thermal process.

In a subsequent step of the preferred method, well defined areas of the first layer of electroluminescent material and of the second layer of organic material (PVA) are ablated to expose certain well defined areas of the substrate. Ablation of said layers can be carried out by exposing said layers to at least one shot/dose of excimer laser radiation with a wavelength of, but not limited to, preferably 322 nm. Care has to be taken not to damage the functionality of the underlying substrate during the ablation process. It might be beneficial in some circumstances not to completely remove the entire layer of electroluminescent material from the well defined areas but to leave a very thin layer of electroluminescent material on the substrate in said well defined areas.

The next step is to deposit a second layer of electroluminescent organic material onto the substrate e.g. via a spin coating process. This leaves a conformal film of organic electroluminescent material covering the exposed, well defined areas of the substrate as well as the upper surface of the second organic layer (PVA). The minimum pixel size that can be filled will depend on the aspect ratio of the pixel, but given the most suitable parameters, this process will allow the filling of openings as small as 1µm. There is no upper limit for the size of the pixel that can be filled using this process.

A fourth layer of material, preferably a water-soluble organic material such as PVA, is subsequently deposited onto the substrate via, for example, a spin coating process. This layer covers the second electroluminescent organic material in such a way as to protect the underlying electroluminescent material from potentially damaging environments and to minimize the exposure of the organic electroluminescent material subsequent laser radiation. Potential damage during the laser ablation process of the functional material could occur via photo oxidation or photo bleaching of the electroluminescent polymer film within the pixel area. An additional advantage of the second PVA layer is that it protects the underlying organic electroluminescent material from any debris that might be produced during the subsequent process steps.

The final step in the process is to remove the sacrificial organic layers (PVA) from the substrate. This could potentially be done using a lift off process by dissolution of the first PVA layer and subsequent lift off of all subsequent layers of the substrate leaving simply the substrate with the first and second electroluminescent material on it. However, organic electroluminescent materials tend to form thin conformal films covering the entire area of the substrate including any layers thereon. Due to the conformity of the second PLED film and the fact that the sidewalls of the pixels are also covered by said second PLED film no solvent capable of dissolving the first layer of protective material (PVA) is able to penetrate into the first layer of PVA. For the lift off process to work, the conformal film of second electroluminescent material has to be punctured or removed from well-defined areas of the substrate to enable the solvent for the second protective organic material (PVA) to penetrate into this layer to dissolve it. This removal process can be achieved by ablating and removing well-defined areas of the second electroluminescent material. After said ablation process the substrate is exposed to a solvent that is able to dissolve the second layer of organic material (PVA) resulting in a lift off process of all subsequent layers. This leaves areas of first and second electroluminescent materials on the substrate.

Repeating the process steps outlined above and changing the emission properties of the organic electroluminescent material used, very high resolution, full-color displays with very small pixel size can be produced. In principal, the same process can be applied to produce displays with a variety of pixel sizes on a variety of substrates.

The methods of the present invention are simple and economical. Furthermore, the methods can be used to fabricate color PLED displays using a wide variety of standard materials and standard process equipment.

In a particular embodiment, the present invention can be used to fabricate high resolution, full-color PLED display having pixels comprising red, green and blue sub-pixels. More preferably, the devices have very small pixel sizes and high brightness and may be "top" emitting or "bottom" emitting displays.

The methods of the present invention allow for patterning of the electroluminescent organic material to fabricate full-color displays that consist of self-emissive pixels. Each pixel contains a number of sub-pixels with each adjacent sub-pixel emitting light of a different color, e.g. red, green and blue light for a full-color display.

In a particular embodiment, the present invention relates to a method of patterning organic electroluminescent pixels onto a substrate. That substrate is structured in such a way that the pixel areas are recessed. The substrate has previously been coated with an organic layer that firstly, facilitates charge injection from the bottom electrode into the device and secondly is largely insoluble in the solvent used to dissolve the electroluminescent organic material and the sacrificial organic material. The organic layer, preferably including polyethylenedioxythiophene (Pedot) and possibly including one or more further substances such as epoxysilane, has been rendered largely insoluble by a heat treatment at 180°C for 15 minutes. The method for defining pixels comprises:
1) Deposition of a first layer of electroluminescent material onto the substrate.
2) Deposition of a second, sacrificial organic layer onto said first organic electroluminescent layer, with the sacrificial organic material having to fulfill at least the requirements of firstly, being largely insoluble in the solvent used to dissolve the organic electroluminescent material. Secondly, the solvent used to dissolve said sacrificial organic material should not damage or dissolve the organic electroluminescent material or the charge injection layer present on the substrate.
3) Ablating the sacrificial organic layer and first layer of organic electroluminescent material in well-defined areas (pixel areas) on the substrate to define areas on the substrate where a second layer of organic electroluminescent material should be located/patterned onto.
4) Deposition of a second layer of organic electroluminescent material onto the substrate so that said second electroluminescent material is in direct contact with the substrate in said well defined areas.
5) Deposition of a second sacrificial organic layer onto the substrate with the second sacrificial organic material having to fulfill at least the requirement that the solvent used to dissolve the sacrificial organic material does not damage or dissolve any of the organic electroluminescent materials or the charge injection layer on the substrate.
6) Ablating well-defined areas of the second electroluminescent material and of the second sacrificial organic layer with for example an excimer laser to enable a suitable solvent, capable of dissolving the first sacrificial organic layer, to gain access to the first sacrificial organic layer.
7) Dissolving the first sacrificial organic layers in a solvent that does not damage any of the electroluminescent material or the injection layer on the substrate leaving a substrate with well-defined areas of thin films of first and second organic electroluminescent material.
   In a preferred version of this embodiment, the method comprises the following further steps:
8) Deposition of a sacrificial organic layer onto the substrate, with the sacrificial organic material having to fulfill at least the requirements that firstly, the sacrificial organic material is largely insoluble in the solvent used to dissolve the organic electroluminescent materials and secondly, the solvent used to dissolve the sacrificial organic material does not damage or dissolve the organic electroluminescent materials.
9) Ablating the sacrificial organic layer and first layer of organic electroluminescent material in well-defined areas of the substrate to define areas on the substrate where the third organic electroluminescent material should be located/patterned onto.
10) Deposition of a third organic electroluminescent material onto the substrate so that that said third organic electroluminescent material is in direct contact with the substrate in said well defined areas.
11) Deposition of a second sacrificial organic layer onto the substrate with the second sacrificial organic material having to fulfill at least the requirement that the solvent used to dissolve the sacrificial organic material does not damage or dissolve any of the organic electroluminescent materials or the charge injection layer on the substrate.
12) Ablating well-defined areas of the third electroluminescent material with for example an excimer laser to enable a solvent to gain access to the first sacrificial organic layer.
13) Dissolving the first sacrificial organic layers in a solvent that does not damage any of the electroluminescent material or the injection layer on the substrate leaving a substrate with well defined areas of thin films of a first, a second and a third layer of organic electroluminescent material.

It is evident that the steps (8) to (13) that were carried out to define a third pixel of electroluminescent material are a repetition of steps (2) to (7) that were used to pattern the second electroluminescent material. The method may further comprise the steps of depositing a top electrode and/or primary encapsulation layers onto said first, second and third layer of organic electroluminescent material on the substrate.

Furthermore it is evident that for certain applications, the process described above can be applied to any number of functional materials that may be required to be patterned onto one substrate.

### BRIEF DESCRIPTION OF THE DRAWINGS

The invention will now be described in more detail, by way of example only, with reference to the accompanying drawings, in which:

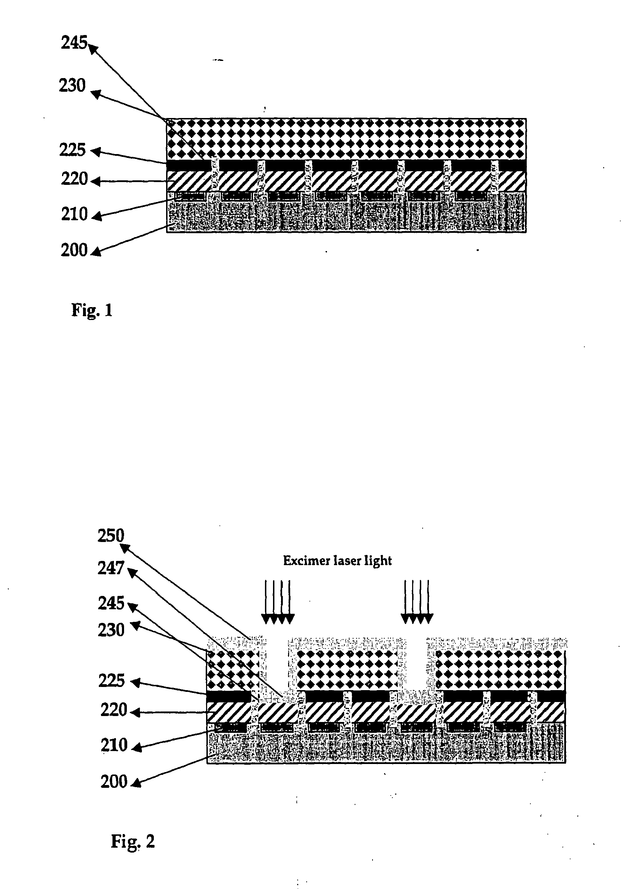

Figures 1 to 7 are schematic sectional views showing sequential steps in the fabrication of an opto-electronic device according to the method of the invention.

### DETAILED DESCRIPTION OF THE INVENTION

Figure 1 shows a device comprising a structured substrate **200,** which can be transparent or opaque, a patterned bottom electrode **210,** which can be a cathode or an anode, and a first organic layer **220.** Said layer **220** facilitates charge injection from the bottom electrode **210** into the device and it must be largely insoluble in the solvent system used to dissolve the electroluminescent organic material and the sacrificial organic material described below.

The layer **220** is a charge injection layer, i.e. a hole transporting layer e.g. Pedot-PSS (polyethylenedioxythiophene-polystyrene sulphonate) if the bottom electrode **210** is an anode, and an electron transport layer if the bottom electrode is a cathode. A second organic layer **225** comprises a functional material e.g. organic electroluminescent material. The solvent used to dissolve the functional material **225** must not damage the functionality of the layer **220.** A third organic layer **230** e.g. of poly(vinyl alcohol) that is insoluble in the solvent system used to dissolve any functional materials (i.e. electroluminescent material) is subsequently deposited. The deposition of said sacrificial organic layer **230** should not cause any non-reversible damage to the functional materials **225** or **220.**

Each element of the bottom electrode represents one sub-pixel in the matrix. The electrodes **210** can be patterned by any method known in the art, including, but not limited to lithographic, particularly photolithographic techniques, laser ablation, and masking during deposition. Sub-Pixel separators **245** are present on the substrate between sub-pixel electrodes helping to avoid any inter-mixing of the organic light emitting materials during the coating process.

As depicted in Figure 2, well-defined areas of the sacrificial organic layer **230** and of the layer of functional material **225** are removed via a laser ablation process to define spaces for the sub-pixels **247** of a second functional material. In the next step the second functional material e.g. for providing sub-pixels emitting light of a second primary color, is deposited onto the substrate, filling in the sub-pixels **247** and forming a conformal thin film **250** over the entire structure as indicated in Figure 2.

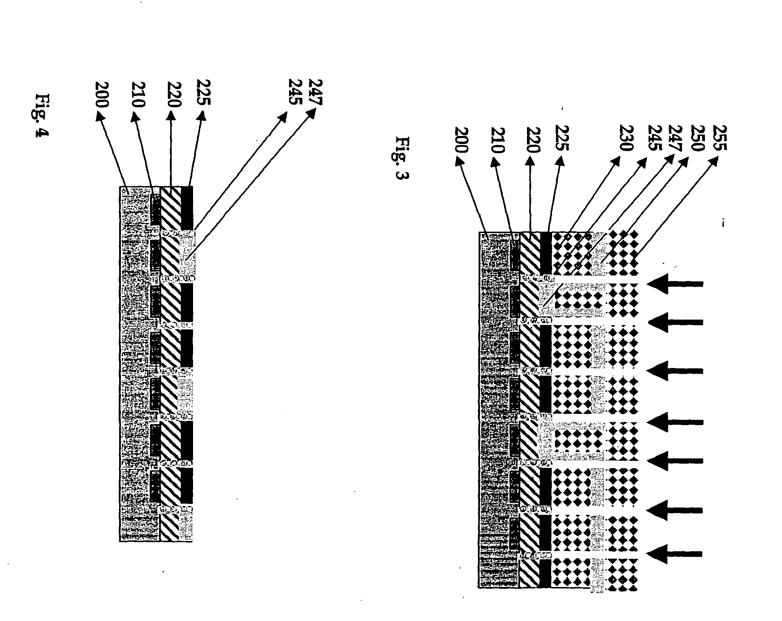

In order to protect the second functional material in the subsequent process steps, the substrate can be coated with a second sacrificial organic layer **255**, that is preferably the same material as used for layer **230.** In the next step, well-defined areas of, at least the sacrificial organic layer **255** and of the conformal film **250** are ablated at the position where the pixel separators are located. Ideally, the sacrificial organic layer **230** should be ablated during this process also. This is illustrated in Figure 3.

As depicted in Figure 4, the next step of the process is to dissolve the sacrificial layers **230** and **255** in a suitable solvent. This results in the removal (lift off) of the conformal layer of functional material **250** that is present between the sacrificial layers **230** and **255** leaving sub-pixels of the functional material **225** and **247** on the substrate.

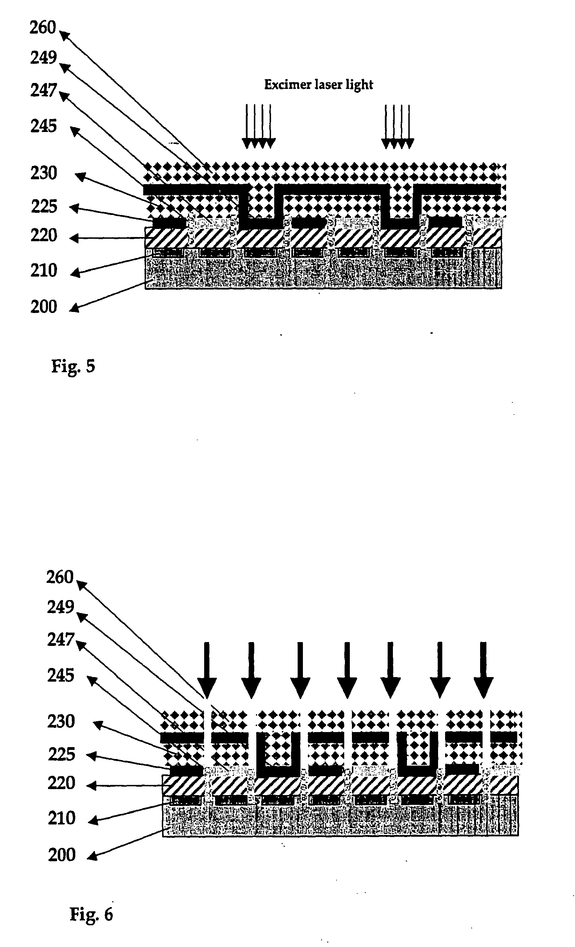

The process steps to pattern a third sub-pixel onto the substrate are a repetition of the process steps that have been illustrated in Figures 1 to 4. The substrate is again coated with a sacrificial organic layer **230** and well defined areas of the sacrificial organic layer **230** and of the layer of functional material **225** are removed via a laser ablation process to define spaces for the sub-pixels **249** of a third functional material. A third functional material **249** is then deposited onto the substrate and another sacrificial organic layer **260** is deposited to protect the third functional material **249** in subsequent process steps. The sacrificial organic layer **260** can be but is not limited to, the same material as used for layers **230** and **255.** The process step described is illustrated in Figure 5.

In the next step, well-defined areas of the conformal film **249** and the sacrificial layer **260** are ablated at the position of the sub-pixel separators. Ideally, the sacrificial organic layer **230** should also be ablated during this process. These steps are illustrated in Figure 6.

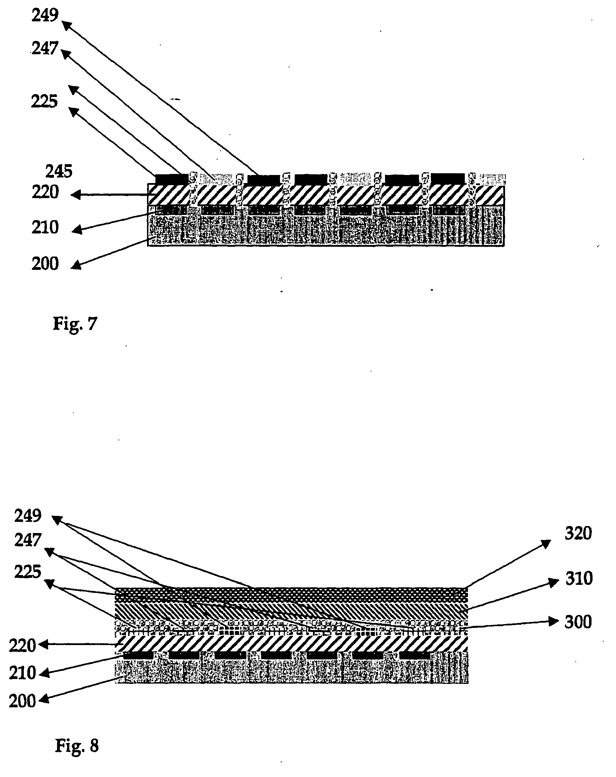

In a final step the sacrificial layers **230** and **260** are dissolved in suitable solvent which results in the lift off of the conformal film of functional material **249** that is sandwiched between the sacrificial layers **230** and **260.** The substrate is left with the three different electroluminescent materials **225, 247,** and **249** present as an array of three sub-pixels as shown in Figure 7.

PLEDs can be fabricated by any method known in the art. The layers of organic material may be formed by evaporation, spin casting, self-assembly or any other appropriate film forming techniques. The thickness of the organic layers can vary between a few monolayers to about 500 nm. In a preferred embodiment, the organic layers are formed by a spin-casting process.

The PLED shown in Figure 8 is by way of example, and any type can be used. For example, a PLED may comprise a hole injection layer adjacent to the anode and at least a second hole-transporting layer adjacent to the hole-injecting layer. The hole injection layer and the hole transport layer may be deposited separately.

A PLED may comprise an electron injection layer and at least one electron transport layer, or the PLED can further comprise an additional layer adjacent to the top electrode. Other PLED structures will be evident to those skilled in the art.

A substrate may be made from any material known in the art, including glass, silicon, plastic, quartz and sapphire. If the PLED display is formed on a silicon chip, the chip preferably includes drive electronics and one of the sub-pixel electrodes, which are isolated by having an insulating wall structure between them, referred to as a sub-pixel separator . The sub-pixel separators also act to guide the emitted light from an activated sub-pixel, perpendicularly upwards rather than parallel to the display substrate.

The top electrode may be common to all sub-pixels.

An anode can have one layer comprising a metal having a high work function, a metal oxide and mixtures thereof. Preferably, the anode comprises a material selected from the group of high work function metal such as gold, platinum, nickel, chromium, or alternatively from the group of conducting or semi-conducting metal oxides or mixed metal oxides such as indium zinc tin oxide, indium zinc oxide, ruthenium dioxide, molybdenum oxide, nickel oxide or indium tin oxide. In one embodiment, the anode further comprises of a thin layer (0.1 to 2 nm) of dielectric material between the anode and the first hole injection/ hole transport layer.

Examples of such dielectric materials include, but are not limited to lithium fluoride, cesium fluoride, silicon oxide and silicon dioxide. In another embodiment, the anode comprises a thin layer of an organic conducting material adjacent to the hole injection/hole transport layer. Such organic conducting materials include, but are not limited to, polyaniline, Pedot-PSS, and a conducting or semiconducting salt thereof.

A semi-transparent cathode **300,** such as used in Figure 8 comprises a single layer of one or more metals or metal oxides, at least one of them having a low work function. Such metals include, but are not limited to, lithium, aluminum, magnesium, calcium, samarium, cesium and mixtures thereof. Additionally further encapsulation layers **310** and **320** could be used in the device fabrication. Layer **310** might comprise very thin, ideally pinhole free films of silicon oxide or silicon nitride. Layer **320** might comprise of a thin layer of glass. In one embodiment, the cathode further comprises a layer of dielectric material adjacent to the electron injection/electron transporting layer, the dielectric material including, but not limited to, lithium fluoride, cesium fluoride, lithium chloride and cesium chloride.
Whilst the specific embodiments of the invention described above are methods of fabricating an opto-electronic display, the invention has application in a number of different fields such as other electronic applications and also in fabricating biomedical devices in which a number of different biochemical reagents, such as proteins, are to be patterned on to a substrate.

All forms of the verb "to comprise" used in this specification have the meaning "to consist of or include".

## Claims

1. A method of patterning a functional material onto a substrate (200), comprising the steps of (a) applying a layer of functional material (225) to at least one major surface of said substrate; (b) applying a layer of protective material (230), soluble in a solvent in which the functional material is insoluble, over said layer of functional material (225); (c) removing areas of said layers of protective and functional materials (230, 225) in well-defined regions on the substrate; and (d) removing the remaining exposed protective material (230) from the substrate (200) by dissolution in said solvent, **characterized in that** after step (c) the following step (e) is carried out in which a second functional material (247) is deposited at least onto the substrate in the well-defined regions; a further layer of protective material (255), soluble in a solvent in which the second functional material is insoluble, is applied over said second functional material (247); areas of said materials (247, 255) that overly the edge of the well-defined regions are removed and after step (d) the remainder of said layer of protective material (230) and any of the second functional material (247) other than in the well-defined regions are removed and **in that** said areas of said materials (247, 255) that overly the edge of the well-defined regions are removed by laser ablation.

2. The method of claim 1, wherein in step (c) said layers of functional material (225) and said layer of protective material (230) are removed from the well-defined regions by laser ablation.

3. The method of claim 1 or 2, wherein after step (d) the remainder of said layer of protective material (230, 255) and any of the second functional material (247) other than in the well-defined regions are removed using a lift off process.

4. The method of claim 1, 2or 3, comprising further steps of patterning a further functional material (249) to the substrate, the further steps comprising repeating step (e).

5. The method of any preceding claim, wherein in step (c) the layer of functional material (225) is not completely removed from the well-defined areas on the substrate.

6. The method of any preceding claim, wherein said substrate (200) comprises glass.

7. The method of any one of claims 1 to 5, wherein said substrate (200) comprises silicon.

8. The method of any one of claims 1 to 5, wherein said substrate (200) comprises plastics material.

9. The method of any preceding claim, wherein said substrate (200) comprises a charge injection layer (220).

10. The method of claim 9, wherein said charge injection layer (220) is patterned.

11. The method of any preceding claim, wherein said at least one major surface of the substrate (200) is structured.

12. The method of claim 11, wherein said at least one major surface of the substrate (200) comprises a raised wall structure (245), which may be of inorganic, organic, or metal material.

13. The method of any preceding claim, wherein said protective material (230) comprises organic material.

14. The method of claim 13, wherein said protective material (230) comprises a water soluble polymer.

15. The method of claim 14, wherein said protective material (230) is selected from poly(vinyl alcohol), polymethyl ether, polymethylacrylamide, doped polythiophene, polyethylene glycol and doped polyaniline.

16. The method of claim 13, wherein said protective material (230) comprises an alcohol soluble polymer.

17. The method of claim 13 wherein said protective material (230) comprises polymers that are soluble in polar solvents such as, or similar to, dimethyl formamide or acetonnitrile.

18. The method of claim 17 wherein said protective material (230) is selected from polystyrene, poly(methylmethacrylate) or poly-ethylene oxide.

19. The method of any one of claims 1 to 12, wherein said protective material (230) comprises inorganic material.

20. The method of claim 19, wherein said protective material (230) is selected from silicon, silicon nitride and silicon oxide.

21. The method of any preceding claim, wherein the functional material (225) is deposited by a method selected from spin coating, evaporation, sputtering and printing.

22. The method of any preceding claim wherein the protective material (230) is deposited by a method selected from spin coating, spraying, evaporation, printing and sputtering.

23. The method of any preceding claim, wherein said functional material (225) comprises an organic electro-optically active material.

24. The method of any one of claims 1 to 20, wherein said functional material (225) comprises a biochemical or biological reagent.

## Patentansprüche

1. Verfahren zur Musterung eines funktionalen Materials auf ein Substrat (200), umfassend die Schritte (a) des Aufbringens einer Schicht eines funktionalen Materials (225) auf wenigstens eine größere Fläche des besagten Substrats; (b) des Aufbringens einer Schicht eines Schutzmaterials (230), welches in einem Lösungsmittel löslich ist, in dem das funktionale Material unlöslich ist, über besagter Schicht des funktionalen Materials (225); (c) des Entfernens von Bereichen besagter Schichten des Schutzmaterials und des funktionalen Materials (230, 225) in klar abgegrenzten Bereichen auf dem Substrat; und (d) des Entfernens des restlichen exponierten Schutzmaterials (230) von dem Substrat (200) durch Lösung in dem besagten Lösungsmittel, **dadurch gekennzeichnet, dass** nach Schritt (c) der folgende Schritt (e) ausgeführt wird, bei dem ein zweites funktionales Material (247) zumindest auf das Substrat in den klar abgegrenzten Bereichen aufgebracht wird; bei dem eine weitere Schicht von Schutzmaterial (255), löslich in einem Lösungsmittel, in welchem das zweite funktionale Material (247) nicht löslich ist, über besagtem zweitem funktionalem Material (247) aufgebracht wird; bei dem Bereiche der besagten Materialien (247, 255), die den Rand der klar abgegrenzten Bereiche überlagern, entfernt werden und wobei nach Schritt (d) der Rest der besagten Schicht des Schutzmaterials (230) und jegliches zweites funktionales Material (247), außer in den klar abgegrenzten Bereichen, entfernt wird, wobei es in den besagten Bereichen der besagten Materialien (247, 255), welche den Rand der klar abgegrenzten Bereiche überlagern, durch Laserablation entfernt wird.

2. Verfahren nach Anspruch 1, wobei in Schritt (c) besagte Schichten des funktionalen Materials (225) und besagte Schicht des Schutzmaterials (230) von den klar abgegrenzten Bereichen mittels Laserablation entfernt werden.

3. Verfahren nach Anspruch 1 oder 2, wobei nach Schritt (d) der Rest der besagten Schicht des Schutzmaterials (230, 255) und jegliches zweites funktionales Material (247), außer in den klar abgegrenzten Bereichen, mittels eines Lift-Off-Prozesses entfernt wird.

4. Verfahren nach einem der Ansprüche 1, 2 oder 3, umfassend weitere Schritte der Musterung eines weiteren funktionalen Materials (249) auf das Substrat, wobei die weiteren Schritte das Wiederholen von Schritt (e) umfassen.

5. Verfahren nach einem der vorangehenden Ansprüche, wobei in Schritt (c) die Schicht des funktionalen Materials (225) nicht vollständig von den klar abgegrenzten Bereichen auf dem Substrat entfernt wird.

6. Verfahren nach einem der vorangehenden Ansprüche, wobei das besagte Substrat (200) Glas umfasst.

7. Verfahren nach einem der Ansprüche 1 bis 5, wobei besagtes Substrat (200) Silizium umfasst.

8. Verfahren nach einem der Ansprüche 1 bis 5, wobei besagtes Substrat (200) Kunststoffmaterial umfasst.

9. Verfahren nach einem der vorangehenden Ansprüche, wobei besagtes Substrat (200) eine Ladungsinjektionsschicht (220) umfasst.

10. Verfahren nach Anspruch 9, wobei besagte Ladungsinjektionsschicht (220) mit einem Muster versehen ist.

11. Verfahren nach einem der vorangehenden Ansprüche, wobei besagte wenigstens eine größere Fläche des Substrats (200) strukturiert ist.

12. Verfahren nach Anspruch 11, wobei besagte wenigstens eine größere Fläche des Substrats (200) eine erhöhte Wandstruktur (245) umfasst, welche aus anorganischem, organischem oder metallischem Material bestehen kann.

13. Verfahren nach einem der vorangehenden Ansprüche, wobei besagtes Schutzmaterial (230) organisches Material umfasst.

14. Verfahren nach Anspruch 13, wobei besagtes Schutzmaterial (230) ein wasserlösliches Polymer umfasst.

15. Verfahren nach Anspruch 14, wobei besagtes Schutzmaterial (230) ausgewählt wird aus Poly(vinylalkohol), Polymethylether, Polymethylacrylamid, dotiertem Polythiophen, Polyethylenglykol und dotiertem Polyanilin.

16. Verfahren nach Anspruch 13, wobei besagtes Schutzmaterial (230) ein alkohollösliches Polymer umfasst.

17. Verfahren nach Anspruch 13, wobei besagtes Schutzmaterial (230) Polymere umfasst, die in polaren Lösungsmitteln, wie z.B. Dimethylformamid oder Acetonitril oder ähnlichem, löslich sind.

18. Verfahren nach Anspruch 17, wobei besagtes Schutzmaterial (230) ausgewählt wird aus Polystyrol, Poly(methylmethacrylat) oder Polyethylenoxid..

19. Verfahren nach einem der Ansprüche 1 bis 12, wobei besagtes Schutzmaterial (230) anorganisches Material umfasst.

20. Verfahren nach Anspruch 19, wobei besagtes Schutzmaterial (230) ausgewählt wird aus Silizium, Siliziumnitrid und Siliziumoxid.

21. Verfahren nach einem der vorangehenden Ansprüche, wobei das funktionale Material (225) mittels einer Methode aufgebracht wird, welche ausgewählt wird aus Spin Coating, Aufdampfen, Sputtern und Drucken.

22. Verfahren nach einem der vorangehenden Ansprüche, wobei das Schutzmaterial (230) mittels einer Methode aufgebracht wird, welche ausgewählt wird aus Spin Coating, Sprühen, Aufdampfen, Drucken und Sputtern.

23. Verfahren nach einem der vorangehenden Ansprüche, wobei besagtes funktionales Material (225) ein organisches, elektrooptisch aktives Material umfasst.

24. Verfahren nach einem der Ansprüche 1 bis 20, wobei besagtes funktionales Material (225) ein biochemisches oder biologisches Reagenz umfasst.

## Revendications

1. Procédé de formation de motifs d'un matériau fonctionnel sur un substrat (200), comprenant les étapes consistant à (a) appliquer une couche de matériau fonctionnel (225) sur au moins une surface majeure dudit substrat ; (b) appliquer une couche de matériau protecteur (230), soluble dans un solvant dans lequel le matériau fonctionnel est insoluble, par-dessus ladite couche de matériau fonctionnel (225) ; (c) éliminer des zones desdites couches de matériaux protecteur et fonctionnel (230, 225) dans des régions bien définies sur le substrat ; et (d) éliminer le matériau protecteur exposé restant (230) du substrat (200) par dissolution dans ledit solvant, **caractérisé en ce que**, après l'étape (c), l'étape suivante (e) est réalisée dans laquelle un second matériau fonctionnel (247) est déposé au moins sur le substrat dans les régions bien définies; une couche supplémentaire de matériau protecteur (255), soluble dans un solvant dans lequel le second matériau fonctionnel est insoluble, est appliquée par-dessus ledit second matériau fonctionnel (247) ; des zones desdits matériaux (247, 255) qui recouvrent le bord des régions bien définies sont éliminées et, après l'étape (d), le reste de ladite couche de matériau protecteur (230) et une partie quelconque du second matériau fonctionnel (247) autre que, dans les régions bien définies sont éliminés, et **en ce que** lesdites zones desdits matériaux (247, 255) qui recouvrent le bord des régions bien définies sont éliminées par coupe au laser.

2. Procédé selon la revendication 1, dans lequel, dans l'étape (c), lesdites couches de matériau fonctionnel (225) et ladite couche de matériau protecteur (230) sont éliminées à partir des régions bien définies par coupe au laser.

3. Procédé selon la revendication 1 ou 2, dans lequel, après l'étape (d), le reste de ladite couche de matériau protecteur (230, 255) et une partie quelconque du second matériau fonctionnel (247) autre que dans les régions bien définies sont éliminés à l'aide d'un procédé de décollage.

4. Procédé selon la revendication 1, 2 ou 3, comprenant des étapes supplémentaires de formation de motifs d'un matériau fonctionnel supplémentaire (249) sur le substrat, les étapes supplémentaires comprenant le fait de répéter l'étape (e).

5. Procédé selon l'une quelconque des revendications précédentes, dans lequel, dans l'étape (c), la couche de matériau fonctionnel (225) n'est pas complètement éliminée des zones bien définies sur le substrat.

6. Procédé selon l'une quelconque des revendications précédentes, dans lequel ledit substrat (200) comprend du verre.

7. Procédé de l'une quelconque des revendications 1 à 5, dans lequel ledit substrat (200) comprend du silicium.

8. Procédé de l'une quelconque des revendications 1 à 5, dans lequel ledit substrat (200) comprend un matériau plastique.

9. Procédé selon l'une quelconque des revendications précédentes, dans lequel ledit substrat (200) comprend une couche d'injection de charge (220).

10. Procédé selon la revendication 9, dans lequel des motifs sont formés sur ladite couche d'injection de charge (220).

11. Procédé selon l'une quelconque des revendications précédentes, dans lequel ladite au moins une surface majeure du substrat (200) est structurée.

12. Procédé selon la revendication 11, dans lequel ladite au moins une surface majeure du substrat (200) comprend une structure de paroi relevée (245), qui peut être de matériau inorganique, organique, ou métallique.

13. Procédé selon l'une quelconque des revendications précédentes, dans lequel ledit matériau protecteur (230) comprend un matériau organique.

14. Procédé selon la revendication 13, dans lequel ledit matériau protecteur (230) comprend un polymère hydrosoluble.

15. Procédé selon la revendication 14, dans lequel ledit matériau protecteur (230) est sélectionné parmi le poly(alcool vinylique), l'éther de polyméthyle, le polyméthylacrylamide, le polythiofène dopé, le glycol polyéthylénique et la polyaniline dopée.

16. Procédé selon la revendication 13, dans lequel ledit matériau protecteur (230) comprend un polymère soluble dans l'alcool.

17. Procédé selon la revendication 13, dans lequel ledit matériau protecteur (230) comprend des polymères qui sont solubles dans des solvants polaires tels que le diméthyl formamide ou l'acétonitrile, ou des solvants polaires similaires à ceux-ci.

18. Procédé selon la revendication 17, dans lequel ledit matériau protecteur (230) est sélectionné parmi le polystyrène, le poly(méthylméthacrylate) ou l'oxyde de polyéthylène.

19. Procédé de l'une quelconque des revendications 1 à 12, dans lequel ledit matériau protecteur (230) comprend un matériau inorganique.

20. Procédé selon la revendication 19, dans lequel ledit matériau protecteur (230) est sélectionné parmi le silicium, le nitrure de silicium et l'oxyde de silicium.

21. Procédé selon l'une quelconque des revendications précédentes, dans lequel le matériau fonctionnel (225) est déposé par un procédé sélectionné parmi un revêtement par centrifugation, une évaporation, une pulvérisation cathodique et une impression.

22. Procédé selon l'une quelconque des revendications précédentes, dans lequel le matériau protecteur (230) est déposé par un procédé sélectionné parmi un revêtement par centrifugation, une pulvérisation, une évaporation, une impression et une pulvérisation cathodique.

23. Procédé selon l'une quelconque des revendications précédentes, dans lequel ledit matériau fonctionnel (225) comprend un matériau organique actif de façon électro-optique.

24. Procédé de l'une quelconque des revendications 1 à 20, dans lequel ledit matériau fonctionnel (225) comprend un réactif biochimique ou biologique.
